# EUROPÄISCHE PATENTSCHRIFT

(11) **EP 2 936 950 B1**
(45) Veröffentlichungstag und Bekanntmachung des Hinweises auf die Patenterteilung: **09.11.2022**
(21) Anmeldenummer: 13798310.2
(22) Anmeldetag: 26.11.2013
(51) Int. Cl.: H05K 3/46, H05K 1/02, H01L 23/15, H01L 23/367, H01L 21/48, H05K 1/16, H01L 33/64

(54) **VERFAHREN ZUR HERSTELLUNG EINES MEHRSCHICHTTRÄGERKÖRPERS**
METHOD FOR PRODUCING A MULTILAYER CARRIER BODY
PROCÉDÉ POUR FABRIQUER UN CORPS SUPPORT MULTICOUCHE

(30) Priorität: 21.12.2012 DE 102012113018
(43) Veröffentlichungstag der Anmeldung: 28.10.2015
(73) Patentinhaber: TDK Electronics AG, 81671 München (DE)
(72) Erfinder: FEICHTINGER, Thomas, A-8010 Graz (AT); PECINA, Axel, A-8543 St. Martin (AT); OBERMAIR, Stefan, A-8510 Stainz (AT); TSCHNUCHNIG, Werner, A-8554 Soboth (AT)
(74) Vertreter: Epping - Hermann - Fischer
(86) Internationale Anmeldenummer: PCT/EP2013/074771
(87) Internationale Veröffentlichungsnummer: WO 2014/095270

(56) Entgegenhaltungen:
- US-A- 5 412 865
- US-A1- 2003 110 629
- US-A1- 2004 134 875
- US-A1- 2005 186 407
- US-A1- 2009 230 596
- US-A1- 2010 181 105
- US-B2- 7 728 234

## Beschreibung

Verfahren zur Herstellung eines Mehrschichtträgerkörpers Bei LTCC- und HTCC-Verfahren (LTCC, Low Temperature Cofired Ceramics oder Niedertemperatur-Einbrandkeramiken; HTCC, High Temperature Cofired Ceramics oder Hochtemperatur-Einbrandkeramiken) werden durch Laser- oder Stanzverfahren strukturierte Folien zur Ausbildung einer Durchkontaktierung erzeugt. Hierdurch lassen sich Strukturen für die 2.5D-Technologie herstellen. Das Basismaterial zum Aufbau eines LTCC- oder HTCC-Keramikwafers können Folien beispielsweise aus einer Glaskeramik im Dickenbereich von 50-150 µm sein. Für dünnere Schichtabstände von unter 10 µm für den Aufbau von sehr dünnen Panelen ist diese Technologie nicht geeignet.

Die durch Lasern erzeugten Durchkontaktierungen beim LTCC/HTCC-Verfahren haben einen Durchmesser im Bereich von 20-100 µm. Durch Stanzen erzeugte Durchkontaktierungen haben einen Durchmesser im Bereich von 50-300 µm. Für größere Öffnungen, deren Durchmesser größer als 500 µm ist, ist die LTCC/HTCC-Technologie eher ungeeignet. Derartige Öffnungen werden ungefüllt für die Ausbildung von Kavitäten oder metallgefüllt für thermische Zwecke, beispielsweise als Wärmesenke in einem Hochleistungs-LED-Träger oder High-Power-LED-Träger, benötigt.

Die Herstellung eines Mehrschichtbauelements mittels mehrerer Druckschritte auf einem Substrat wird in der EP 2381451 beschrieben.

Die US 2009/230596 A1 beschreibt die Herstellung eines Mehrschichtbauelementkörpers, bei der leitende und isolierende Bereiche auf keramischen Schichten aufgebracht werden, die anschließende gestapelt werden.

Die US 2005/186407 A1 beschreibt ein Verfahren, bei dem leitende Strukturen auf keramischen Folien gedruckt werden, und beim Stapeln dieser Folien keramischen Zwischenschichten zwischen den Folien eingebracht werden.

Die US 2004/134875 A1 beschreibt die Herstellung eines Mehrschichtbauelementkörpers, bei der leitende Strukturen auf einem Träger aufgebracht werden, dann eine sowohl den Träger als auch die Strukturen bedeckende Schicht aus keramischen Material aufgetragen wird und dann die Schichtbereiche auf den leitenden Strukturen abgetragen werden, sodass eine Folie mit leitenden und isolierenden Bereichen entsteht.

Die US 2003/110629 A1 und die US 2010/181105 A1 zeigen Mehrschichtbauelementkörper aus Folien mit leitenden und isolierenden Bereichen.

Die US 7728234 B2 zeigt einen Mehrschichtbauelementkörper aus Folien mit leitenden und isolierenden gedruckten Bereichen.

Die US 5412865 A zeigt ein Verfahren zur Herstellung von Mehrschichtbauelementkörpern, bei denen auf leitenden gedruckten Strukturen eine Folie aufgebracht wird.

Es stellt sich die Aufgabe, ein Verfahren zur Herstellung eines Mehrschichtträgerkörpers anzugeben.

Das Verfahren zur Herstellung eines Vielschicht- oder Mehrschichtträgerkörpers umfasst: Fertigen von Folien durch Drucken eines ersten Areals mit einer ersten Paste und Drucken eines zweiten Areals mit einer zweiten Paste, wobei das Drucken als Aufbringen der Pasten auf einem Träger, von dem die abgetrockneten Pasten als Folie abgelöst werden, erfolgt, Stapeln der Folien und Laminieren. Ein freies Areal bleibt in zumindest einer der Folien unbedruckt oder ein drittes Areal wird mit einer dritten Paste gedruckt.

Durch das Drucken des ersten und zweiten Areals innerhalb einer Folienkontur wird eine Folie für einen Folienstapel hergestellt. Eine Folie ist ein dünnes Blatt geformt aus gedruckten Arealen der getrockneten ersten und zweiten Paste. Sie umfasst das gedruckte erste und zweite Areal, deren Dicke der Foliendicke entspricht. Ein drittes Areal kann mit einer dritten Paste gedruckt werden. Weitere Druckschritte zum Drucken weiterer Areale mit weiteren Pasten können vorgesehen sein. Das Drucken erfolgt als Aufbringen der Pasten auf einem Träger, von dem die abgetrockneten Pasten als Folie abgelöst werden. Es werden mehrere Folien gleichzeitig und miteinander verbunden als Bogen gedruckt, sodass die Folien für mehrere Stapel beim Stapeln als Bogen verbunden vorliegen und in einem späteren Schritt vereinzelt werden.

Mit diesem Verfahren lassen sich Mehrschichtträgerkörper mit beliebig geformten Strukturen im Trägersubstrat herstellen, indem Folien gestapelt werden, deren Strukturen Schnitten durch den gewünschten Mehrschichtträgerkörper entsprechen. So lassen sich beispielsweise Mehrschichtkeramikkörper mit integrierter Wärmesenke für die 2.5D- und die 3D-Technologie herstellen.

Das Drucken kann durch ein Siebdruckverfahren oder ein Ink-Jet-Druckverfahren erfolgen. Das Siebdruckverfahren ist ein Mehrfachsiebdruckverfahren, bei dem die Areale nacheinander mit verschiedenen Pasten gedruckt werden. Die Schichtdicke kann geringer als 20 µm sein und im Bereich von 10 µm liegen.

Dieses Verfahren ist für großflächige Strukturen geeignet. Das Ink-Jet-Verfahren, bei dem kleine Pastentröpfen auf den Träger anschlagfrei aufgebracht werden, ist für feine Strukturen, so genannte Fine-Line-Strukturen, geeignet.

Üblicherweise wird zunächst eines der Areale gedruckt. Nach dem Trocknen der Paste erfolgt das Drucken des anderen Areals. Beim Laminieren wirkt Wärme auf die Folien ein, um eine innige Verbindung zwischen den Pastenstrukturen der Areale zu erreichen.

Eine Paste der ersten und zweiten Paste ist eine Keramikpaste, und die andere Paste ist eine Paste mit metallenen Bestandteilen. Mit letztgenannter werden die Areale bedruckt, die Durchkontaktierungen oder integrierte Wärmesenken ausbilden. Auch Polymerpasten können Verwendung finden.

Weitere Herstellungsschritte neben dem Drucken und Trocknen der ersten Paste, zum Beispiel einer Keramikpaste, und dem Drucken und Trocknen der zweiten Paste, zum Beispiel einer Metallpaste, sowie weiteren Druckschritten mit weiteren Pasten sind das Stapeln der Folien und das Laminieren. Beim Laminieren werden die gestapelten Folien innig verbunden. Im selben Schritt oder in einem separaten vorhergehenden Laminierschritt können die verschiedenen Pasten in einer Folienebene an den Grenzflächen innig miteinander verbunden werden. Weitere Herstellungsschritte sind das Pressen, bei dem Druck während des Laminiervorgangs auf den Folienstapel aufgebracht werden kann, das Entkohlen des gepressten Folienstapels sowie das Sintern. Optional kann anschließend eine Isolationsschicht aufgesputtert werden, um eine elektrische Isolierung der integrierten Wärmesenke zu erreichen. Ferner kann eine Leiterstruktur aufgebracht werden, welche beispielsweise eine Umverdrahtung formen kann. Eine solche Leiterstruktur kann aufgedruckt werden. Eine Reflexionsschicht kann beispielsweise durch Drucken aufgebracht werden. Eine solche Reflexionsschicht kann bei LED-Trägern vorgesehen sein. Solche Oberflächenstrukturierungsprozesse umfassen beispielsweise Metallisierungsprozesse wie Sputtern und photolithografische Verfahren.

Es ist auch möglich, den aus den mehrfach gedruckten Folien aufgebauten Stapel mit einem weiteren Folienstapel oder einer oder mehreren anderen Folien, beispielsweise zu Isolationszwecken oder zur Erhöhung der mechanischen Festigkeit, zu verbinden. Dies kann beispielsweise durch Laminieren erfolgen. Ein solcher weiterer Folienstapel kann ein in LTCC/HTCC-Technologie gefertigter Keramikfolienstapel sein.

Das beschriebene Mehrfach-Pastenschichtverfahren ermöglicht die Herstellung von 2.5D- und 3D-Vielschichtwaferstrukturen aus Keramiken, Metallen und Polymeren mit sehr dünnen Schichtabständen, die geringer als 20 µm sind, und komplexen Strukturen von Durchkontaktierungen und Kavitäten.

Kavitäten und Hohlräume lassen sich ausbilden, indem bei übereinander geschichteten Folien freie Areale auf den Folien ungedruckt bleiben. Boden oder Decke der Kavitäten und Hohlräume werden durch in diesem Bereich gedruckte Folien gebildet.

Die Areale können separate Teilareale aufweisen, die mit derselben Paste gedruckt sind. Die Folien können derart bedruckt werden, dass ein Teilareal des ersten Areals das zweite Areal oder ein Teilareal dessen in einer Schnittebene umgibt, in dem seinerseits ein Teilareal des ersten Areals ist. Alternativ kann vorgesehen sein, dass das erste Areal oder ein Teilareal dessen das zweite Areal oder dessen Teilareal in einer Schnittebene umgibt, in dem seinerseits ein freies Areal oder ein drittes Areal ist. Die Schnittebene verläuft entlang einer Folienschicht des Mehrschichtträgerkörpers. Somit lassen sich ineinander geschachtelte Strukturen im Mehrschichtträgerkörper ausbilden, bei denen in einer Struktur weitere Strukturen oder Kavitäten vorgesehen sind.

Durch gestapelte Folien mit gleichen Arealskonturen können Strukturen mit unverändertem Querschnitt entlang der Hochachse des Mehrschichtträgerkörpers, also der Senkrechten zu den Schichten, geformt werden. Die gestapelten Folien können aber auch derart gestaltet werden, dass die Konturen der Areale von aufeinanderliegenden Folien unterschiedlich geformt sind. Somit lassen sich Strukturen formen, deren Querschnitt sich entlang der Hochachse verändert. Erste Areale einer Folie und zweite Areale einer benachbarten Folie können überlappen, oder das erste Areal einer Folie oder mehrerer Folien kann zumindest teilweise zwischen zweiten Arealen darüber und darunter benachbarter Folien liegen, sodass ein Strukturbereich geformt wird, der in das andere Material hineinragt.

Die dreidimensionale Struktur im Mehrschichtträgerkörper entsteht durch die aufeinanderliegenden Strukturen, das heißt Areale aus derselben Paste, der gestapelten Folien. Senkrechte Mantelflächen parallel zur Hochachse der dreidimensionalen Struktur entstehen durch aufeinandergestapelte Folien, bei denen die Konturen, das heißt die Arealsränder, übereinstimmen. Kurvige Mantelflächen der dreidimensionalen Struktur entstehen durch Folien, bei denen die Konturen von Schicht zu Schicht derart geringfügig einander abweichen, sodass sie aufeinandergeschichtet den kurvigen Mantelverlauf ergeben. Kanten im Mantel lassen sich erzielen, indem die Kontur eines Strukturbereichs signifikant von der darunterliegenden Kontur abweicht, sodass das über die darunterliegende Kontur hinausreichende Areal die Unterseite eines Strukturbereichs bildet, der eine Kante an der Schichtgrenze aufweist. Diese Kante verläuft folglich senkrecht zur Hochachse.

Der Mehrschichtträgerkörper kann ein Substrat aufweisen, in dem ein strukturierter Funktionsbereich, das heißt eine Struktur, ist, wobei das Substrat sich sowohl seitlich als auch zumindest teilweise oberhalb und unterhalb des Funktionsbereichs erstreckt und/oder wobei das Substrat sich sowohl seitlich als auch gänzlich oberhalb und/oder unterhalb des Funktionsbereichs erstreckt und/oder wobei das Substrat oder ein weiterer Bereich im Funktionsbereich oder darin hineinragend angeordnet ist.

Nachfolgend wird die Erfindung unter Bezugnahme auf die Zeichnung anhand von Ausführungsbeispielen erklärt.

Es zeigen:
- Figur 1: eine Aufsicht auf ein Ausführungsbeispiel eines Mehrschichtträgerkörpers und einen Schnitt durch diesen,
- Figur 2: zeigt eine Aufsicht auf ein weiteres Ausführungsbeispiel eines Mehrschichtträgerkörpers,
- Figur 3: eine Aufsicht auf ein weiteres Ausführungsbeispiel eines Mehrschichtträgerkörpers und einen Schnitt durch diesen,
- Figur 4: eine Aufsicht auf ein weiters Ausführungsbeispiel eines Mehrschichtträgerkörpers und einen Schnitt durch diesen,
- Figuren: 5 bis 7 Schritte des Herstellungsprozesses anhand von Zwischenprodukten, und
- Figuren: 8 bis 10 Schnitte durch ein weiteres Ausführungsbeispiel eines Mehrschichtträgerkörpers.

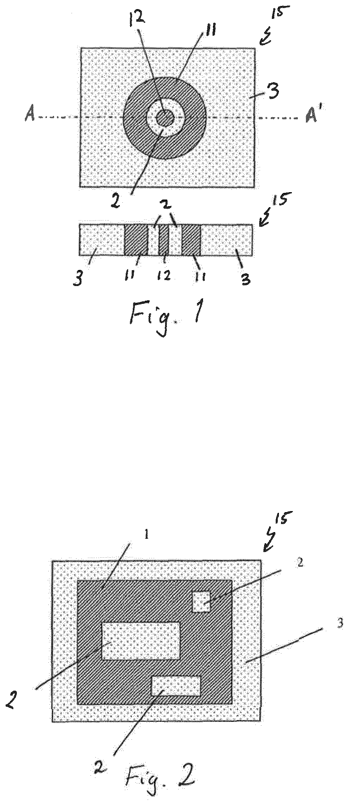

Figur 1 zeigt eine Aufsicht (oben) auf ein Ausführungsbeispiel eines Mehrschichtträgerkörpers und einen Schnitt (unten) durch diesen entlang der Linie A-A'.

Der Mehrschichtträgerkörper 15 weist ein Substrat 3 auf, das eine hohlzylinderförmige Struktur 11, das heißt einen Bereich, mit ringförmigem Querschnitt umgibt. Innerhalb dieser Struktur 11 ist eine weitere zylinderförmige Struktur 12 mit kreisförmigem Querschnitt, wobei zwischen den Strukturen 11 und 12, die metallen sein können, ein hohlzylinderförmiger Substratbereich 2 ist. Die Substratbereiche 3, 2 können aus demselben oder verschiedenen Keramikmaterialien sein. Die Strukturen 11, 12, 2 haben senkrechte Mantelflächen.

Der Mehrschichtträgerkörper 15 ist aus einer Vielzahl identischer Folien aufgebaut, deren Areale wie in der Aufsicht ersichtlich bedruckt worden sind. Wenn dasselbe Material für die Substratbereiche 3, 2 verwendet wird, werden die Teilareale des ersten Areals 3, 2 mit derselben Keramikpaste gedruckt. Nach dem Trocknen werden die Teilareale 11, 12 des zweiten Areals mit einer anderen Paste, die beispielsweise Metallkomponenten umfasst, gedruckt.

In einem alternativen Ausführungsbeispiel ist der holzylinderförmige Bereich 2 aus einem Material geformt, das sich von dem der anderen Bereiche unterscheidet. In diesem Fall wird das entsprechende Areal 2 mit einer dritten Paste in einem weiteren Schritt gedruckt.

Die Stapelung solch identischer Folien mit identischen Konturen ergibt einen Mehrschichtträgerkörper 15, bei dem die Mantelflächen der Strukturen, die sich aus den übereinanderliegenden Konturen ergeben, parallel zur Hochachse des Trägerköpers, das heißt senkrecht zu den Schichten, verlaufen.

Derartige ineinandergeschachtelten Strukturen, wie auch die folgenden, lassen sich mit Standard-LTCC/HTCC-Verfahren nicht herstellen.

Figur 2 zeigt eine Aufsicht auf ein weiteres Ausführungsbeispiel eines Mehrschichtträgerkörpers.

Die Beschreibung konzentriert sich auf die Unterschiede zum vorhergehenden Ausführungsbeispiel.

In diesem Ausführungsbeispiel ist eine Struktur 1, beispielsweise eine Metallstruktur, mit rechteckiger Außenkontur von einem Keramiksubstrat 3 aus einem ersten Material umgeben. In dieser Struktur 1 sind drei rechteckförmige durch den Mehrschichtträgerkörper 15 durchgehende Strukturen 2 mit rechteckigem Querschnitt aus einem weiteren Keramikmaterial vorgesehen, das sich von dem äußeren Substrat 3 unterscheidet. Diese quaderförmigen Strukturen 2 können alternativ aus dem gleichen Material wie das außen liegende Substrat 1 sein oder aus mehreren voneinander verschiedenen Materialien.

Der Mehrschichtträgerkörper 15 ist aus einer Vielzahl identischer Folien aufgebaut, deren Areale wie in der Aufsicht ersichtlich gedruckt sind. Das außen liegende erste Areal 3 ist mit einer Keramikpaste gedruckt worden. Danach ist das darin liegende zweite Areal 2 mit einer Metallpaste gedruckt worden. Falls die im zweiten Areal 1 liegenden Rechtecke 2 mit derselben Paste wie das außen liegende Areal 3 gedruckt sind, können sie im selben Schritt gedruckt werden. Andernfalls erfolgt ihr Druck in einem oder mehreren weiteren Schritten mit einer weiteren Paste oder weiteren Pasten.

Die Stapelung solch identischer Folien mit identischen Konturen ergibt einen Mehrschichtträgerkörper 15, bei dem die Mantelflächen der Strukturen 1, 2, die sich aus den übereinanderliegenden Konturen ergeben, parallel zur Hochachse des Trägerköpers, das heißt senkrecht zu den Folienschichten, verlaufen.

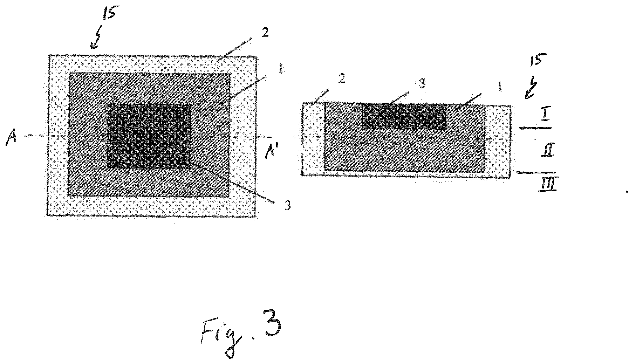

Figur 3 zeigt eine Aufsicht (links) auf ein weiteres Ausführungsbeispiel eines Mehrschichtträgerkörpers und einen Schnitt (rechts) durch diesen entlang der Linie A-A'.

In diesem Ausführungsbeispiel ist eine wannenförmige metallene Struktur 1 an den Seitenflächen und am Boden von einem Keramiksubstrat 2 umgeben. In der Struktur 1 ist eine weitere, quaderförmige Struktur 3 aus einem weiteren Material, beispielsweise einem anderen Keramikmaterial, vorgesehen.

Dieser Mehrschichtträgerkörper 15 ist aus drei verschiedenen Folientypen aufgebaut. Im oberen Bereich I entspricht deren Arealsanordnung der Aufsicht. Das rechteckförmige dritte Areal 3 ist von den rahmenförmigen zweiten und ersten Arealen 1, 2 umgeben. Im darunterliegenden Bereicht II weisen die Folien ein zweites Areal 1 ohne Innenkontur auf. Das zweite Areal 1 ist rechteckförmig. Im unteren Bereich III sind die Folien ganzflächig mit der Paste für das erste Areal 2 bedruckt.

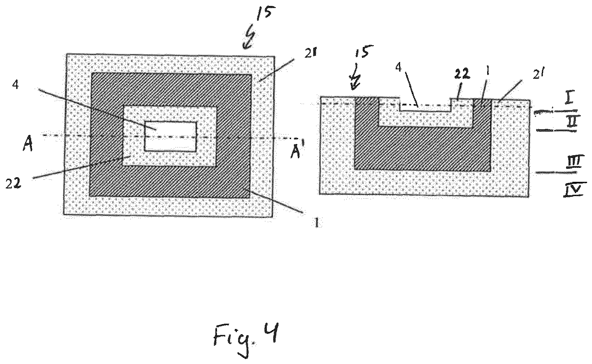

Figur 4 zeigt eine Aufsicht (links) auf ein weiteres Ausführungsbeispiel eines Mehrschichtträgerkörpers und einen Schnitt (rechts) durch diesen entlang der Linie A-A'.

In diesem Ausführungsbeispiel ist eine wannenförmige metallene Struktur 1 an den Seitenflächen und am Boden von einem Keramiksubstrat 21 umgeben. In der Struktur 1 ist eine weitere wannenförmige Struktur 22 aus dem Keramikmaterial der Außenwanne 21 vorgesehen, in der eine quaderförmige Kavität 4 ist.

Dieser Mehrschichtträgerkörper 15 ist im oberen Bereich I aus geschichteten Folien aufgebaut, deren Areale 4, 22, 1, 21 wie in der Aufsicht dargestellt gedruckt sind. Die Kavität 4 wird durch ein freies Areal 4, das heißt einer ungedruckten Folienaussparung, gebildet. Im darunterliegenden Bereich II unterscheiden sich die Folien von denen im oberen Bereich I dadurch, dass das innen liegende Teilareal 22 keinen freien Bereich mehr aufweist, sondern rechteckförmig ist. Seine Außenkontur ist unverändert. Im darunterliegenden Bereich III unterscheiden sich die Folien von denen im Bereich II dadurch, dass das Metallareal 1 rechteckförmig ist. Seine Außenkontur ist unverändert. Im darunterliegenden Bereich VI sind die Folien ganzflächig mit der Paste für das erste Areal 21 bedruckt. Benachbarte Folien, bei denen verschiedene Areale aufeinander liegen, formen die waagerechten Grenzflächen zwischen den wannenförmigen Strukturen 21, 1, 22.

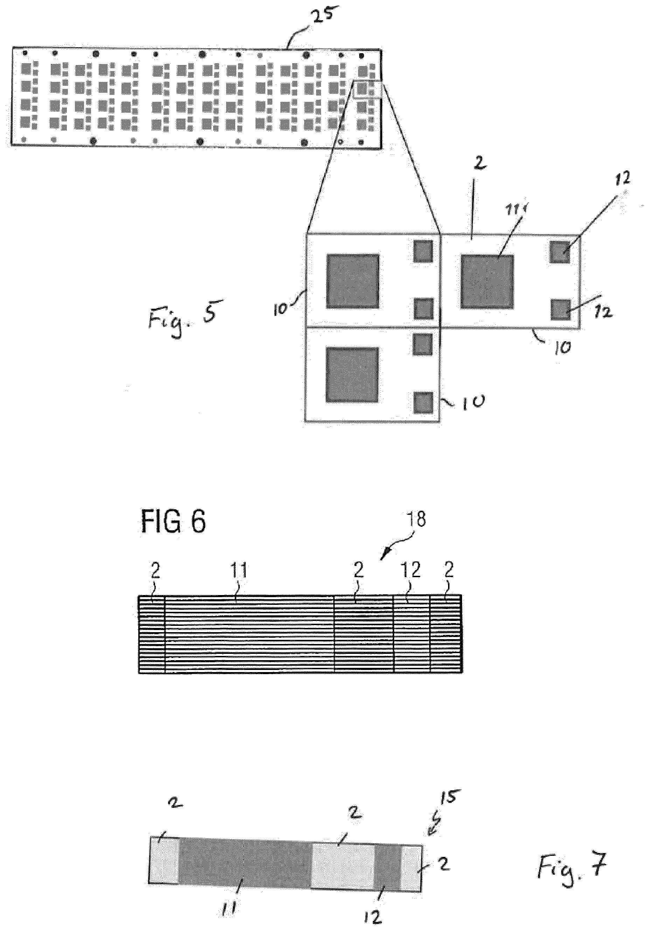

Die Figuren 5 bis 7 veranschaulichen die exemplarische Herstellung eines Mehrfachschichtträgerkörpers anhand von Zwischenprodukten.

Zunächst werden auf einen Träger oder einer Trägerfolie 25 in einem Schritt die ersten Areale 2 für eine Vielzahl von Folien 10 gedruckt, die zunächst noch in einem Bogen verbunden sind. Nach dem Trocknen der Keramikpaste werden auf dem Träger 25 die zweiten Areale 11, 12, welche drei Teilareale 11, 12 umfassen, mit einer Metallpaste gedruckt, die ebenfalls trocknet.

Figur 5 zeigt einen Bogen mit einer Vielzahl fertig gedruckter Folien 10 mit ersten und zweiten Arealen 2, 11, 12. Die Ausschnittsvergrößerung zeigt die Folien 10 dieses Bogens im Detail.

Anschließend werden die Pastenstrukturen laminiert. Beim Laminieren, Verstapeln und Pressen der Folienbögen werden diese zu Stapeln aufeinander gelegt und bei Wärme- und Druckeinwirkung innig miteinander verbunden. Figur 6 zeigt einen solchen Stapel 18 nach Laminieren und Verpressen.

Beim nachfolgenden Entkohlen und Sintern werden organische Bestandteile thermisch entfernt und die Schichten fest zum Mehrschichtträgerkörper 15 verbunden. Figur 7 zeigt solch einen Mehrschichtträgerkörper 15 nach dem Entkohlen und Sintern.

Optional können weitere Schichten und Strukturen auf dem Mehrschichtträgerkörper 15 aufgebracht werden, um daraus einen Bauelementträger zu fertigen. Weitere Schritte können beispielsweise umfassen, eine Isolationsschicht zu sputtern. Der Mehrschichtträgerkörper 15 kann mit einer Leiterstruktur, beispielsweise einer Umverdrahtung, bedruckt werden. Optional kann eine Reflexionsschicht aufgedruckt werden, um den Mehrschichtträgerkörper 15 beispielsweise als LED-Träger einzusetzen.

Außerdem ist eine Vereinzelung des Stapels zur Ausbildung der Mehrschichtträgerkörper 15 erforderlich. Dies kann ein sich an die Oberflächenstrukturierung anschließender Schritt sein.

Außer dem oben beschriebenem Verfahren zur Herstellung eines Vielschichtpastenaufbaus ist auch ein Mischaufbau aus Vielschichtpastenfolien und konventionellen Folien denkbar. Das Verfahren zu seiner Herstellung unterscheidet sich von dem obigen dadurch, dass nach dem Laminieren der Pastenfolien noch ein Laminieren des Pastenstapels mit dem konventionell hergestellten Folienstapel vorgesehen ist. Anschließend erfolgen ebenfalls Verpressen, Entkohlen und Sintern sowie Oberflächenstrukturierungsprozesse, wie oben geschildert.

Durch dieses Verfahren wird ein Mehrschichtträgerkörper aus gestapelten gedruckten Folien, die mit verschiedenen Pasten gedruckte Areale aufweisen, hergestellt. Die Reihenfolge der Verfahrensschritt kann variieren.

Auf diese Weise lässt sich beispielsweise eine 2.5D- oder 3D-Vielschichtstruktur herstellen.

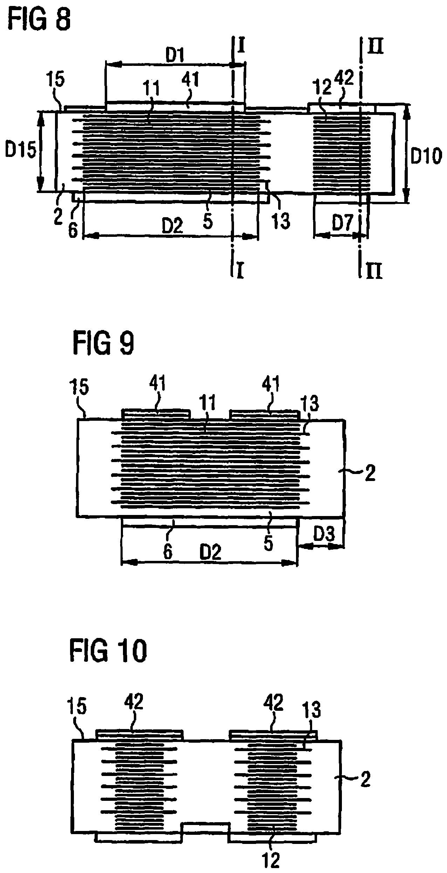

Figur 8 zeigt einen Schnitt durch das Ausführungsbeispiel des Mehrschichtträgerkörpers, das durch das geschilderte Herstellungsverfahren gefertigt wurde. Die Figur 9 zeigt einen Schnitt durch das Ausführungsbeispiel des Mehrschichtträgerkörpers entlang der Linie I-I. Die Figur 10 zeigt einen Schnitt durch das Ausführungsbeispiel des Mehrschichtträgerkörpers entlang der Linie II-II.

Der Mehrschichtträgerkörper 15 dient als LED-Träger, auf dem eine LED als Bauelement mit starker Wärmeentwicklung sowie ein weiteres Bauelement montiert werden kann. Zu diesem Zweck sind auf der Oberseite des Trägerkörpers 15 Lötpads 41, 42 vorgesehen, auf denen die Bauelemente (nicht dargestellt) fixiert werden können.

Dieses Ausführungsbeispiel umfasst drei strukturierte Funktionsbereiche 11, 12. Eine Struktur, die ein erster Funktionsbereich 11 ist, erstreckt sich unterhalb der Lötpads 41 für die LED und verläuft von der Oberseite des Mehrschichtträgerkörpers 15 bis zu einer Isolationsschicht 5 an der Unterseite des Mehrschichtträgerkörpers. Diese Isolationsschicht 5 kann aus demselben Material wie das den ersten Funktionsbereich 11 umgebende Substrat 2 sein. Dieser als Wärmesenke dienende Funktionsbereich 11 hat einen zylinderförmigen, in diesem Fall quaderförmigen Grundkörper. Aus der senkrechten Mantelfläche des Grundkörpers ragen waagerecht verlaufende Bereiche 13 ins Substrat 2, die als strukturierte Schichten ausgebildet sind. Diese strukturierten Schichten können jeweils aus einer oder mehreren Folienschichten gefertigt sein. Diese ins Substrat 2 hineinragenden Bereiche 13 können eine Querschnittsvergrößerung des Grundkörpers sein, deren Kontur einen gleichen Abstand von der Kontur des Grundkörpers hat. Sie können alternativ streifen- oder stegförmig ausgebildet sein. Wegen ihrer Form können sie auch als Elektrodenstruktur bezeichnet werden. Sie verbessern die mechanische Anpassung zwischen Metall und Keramik im Übergang vom Substrat 2 zum Funktionsbereich 11, indem beispielsweise Materialspannungen vermieden werden.

An der Unterseite des Mehrschichtträgerkörpers 15 ist ein Anschluss 6 montiert.

Der Mehrschichtträgerkörper 15 weist außerdem einen zweiten und dritten Funktionsbereich 11 auf, die von der Oberseite des Mehrschichtträgerkörpers 15 zu dessen Unterseite verlaufen.

Diese Funktionsbereiche 11 sind zylinderförmig mit rechteckigem Querschnitt. Sie können als Durchkontaktierung oder integrierte Wärmesenken für ein weiteres Bauelement (nicht dargestellt) dienen.

Die Breite D1 eines Lötpads 41 für die LED entspricht der Breite der darauf zu montierenden LED und kann beispielsweise 1000 µm betragen. Die Breite D7 für das weitere Bauelement entspricht dessen Breite und kann 300 µm betragen.

Ein solcher Trägerkörper 15 mit Oberflächenstrukturen kann eine Dicke D10 von 500 µm haben, wobei das Substrat 2 eine Dicke D15 von 400 µm hat.

Im Substrat 2 sind der erste Funktionsbereich 11, der als thermischer Block oder Wärmesenke für die LED dient, sowie zwei weitere Funktionsbereiche 12 angeordnet. Auf der Unterseite des Trägerkörpers 15 sind Anschlüsse 6 angeordnet. Die Breite D2 des Grundkörpers der integrierten Wärmesenke beträgt sowohl in Längs- als auch Querrichtung 1500 µm. Der Abstand D3 zum Rand des Trägerkörpers beträgt 700 µm (siehe Figur 9). Die Breite der weiteren Funktionsbereiche 12 entspricht der des weiteren Bauelements 7 und beträgt 300 µm.

Der Trägerkörper 15 hat einen geschichteten Aufbau und umfasst eine Vielzahl von aus Pasten gedruckten Folien 10, die gestapelt und laminiert wurden, um den Trägerkörper 15 zu formen. Das Substrat 2 ist aus Keramikschichten und die darin liegenden Strukturen 11, 12 aus Metallschichten, die beispielsweise Kupfer aufweisen, ausgebildet. Auf diese Weise ist es möglich, beliebige Strukturen innerhalb des Substrats 2 herzustellen. So lassen sich beispielsweise die aus dem Grundkörper des Funktionsbereichs herausragenden Bereiche 22 in einfacher Weise fertigen, indem das Metallareal einer solchen Schicht über den der darunterliegenden Schicht hinausragt.

Figur 9 und Figur 10 zeigen zwei weitere Schnitte durch das Bauelement entlang der Linien I-I und II-II in Figur 8. Figur 9 zeigt den Schnitt I-I, in dem deutlich erkennbar ist, dass die LED mittels zweier Kontakte 41 kontaktiert wird. Im Schnitt II-II ist erkennbar, dass Gleiches auch für das weitere Bauelement gilt. Zudem ist erkennbar, dass auch aus den Grundkörpern der zweiten und dritten Funktionsbereiche 12 waagerecht verlaufende Bereiche 13 ins Substrat 2 ragen, die als strukturierte Schichten ausgebildet sind, allerdings nur in eine Hauptrichtung. Aus dem Grundkörper des ersten Funktionsbereichs 11 ragen waagerecht verlaufende Bereiche 13 ins Substrat 2 in Längs- und Querrichtung, wie sie in den Figuren 9 und 10 erkennbar sind.

Die Merkmale der Ausführungsbeispiele können kombiniert werden.

## Patentansprüche

1. Verfahren zur Herstellung eines Mehrschichtträgerkörpers (15) umfassend:
- Fertigen von Folien (10) durch Drucken eines ersten Areals (2, 21, 22, 1, 11, 12, 3) mit einer ersten Paste und Drucken eines zweiten Areals (2, 21, 22, 1, 11, 12, 3) mit einer zweiten Paste, wobei das Drucken als Aufbringen der Pasten auf einem Träger, von dem die abgetrockneten Pasten als Folie (10) abgelöst werden, erfolgt,
- Stapeln der Folien (10),
- Laminieren,
**dadurch gekennzeichnet, dass** ein freies Areal (4) in zumindest einer der Folien (10) unbedruckt bleibt oder dass ein drittes Areal (3) mit einer dritten Paste gedruckt wird.

2. Verfahren nach Anspruch 1,
wobei das Drucken durch ein Siebdruckverfahren oder ein Ink-Jet-Druckverfahren erfolgt.

3. Verfahren nach Anspruch 1 oder 2,
wobei das erste und zweite Areal (2, 21, 22, 1, 11, 12, 3) in einer der Folien (10) zumindest teilweise aneinander grenzen.

4. Verfahren nach einem der vorhergehenden Ansprüche,
wobei zumindest eine der Folien (10) derart gedruckt wird, dass zumindest eines der Areale (2, 21, 22, 1, 11, 12, 3) voneinander separate Teilareale (21, 22, 11, 12) umfasst.

5. Verfahren nach einem der vorhergehenden Ansprüche,
wobei Folien (10) derart gedruckt werden,
- dass ein Teilareal (21) des ersten Areals das zweite Areal (1) oder ein Teilareal dessen umgibt, in dem seinerseits ein Teilareal (22) des ersten Areals ist, oder
- dass das erste Areal (2) oder ein Teilareal dessen das zweite Areal (1) oder dessen Teilareal umgibt, in dem seinerseits ein freies Areal (4) oder ein drittes Areal (3) ist.

6. Verfahren nach einem der vorhergehenden Ansprüche,
wobei die Folien (10) derart aufeinander gestapelt werden, dass die Konturen der Areale von benachbarten Folien (10) unterschiedlich geformt sind.

7. Verfahren nach einem der vorhergehenden Ansprüche,
wobei die Folien (10) derart gestapelt werden,
- dass das erste Areal (2, 21, 22, 1, 11, 12, 3) einer Folie (10) und das zweite Areal (2, 21, 22, 1, 11, 12, 3) einer benachbarten Folie (10) überlappen, oder
- dass das erste Areal (13) einer Folie (10) oder mehrerer aufeinanderliegender Folien (10) zumindest teilweise zwischen zweiten Arealen (2) benachbarter Folien (10) liegt, oder
- dass das zweite Areal (13) einer Folie (10) oder mehrerer aufeinanderliegender Folien (10) zumindest teilweise zwischen ersten Arealen (2) benachbarter Folien (10) liegt.

8. Verfahren nach einem der vorhergehenden Ansprüche,
wobei eine Paste der ersten und zweiten Paste eine Keramikpaste ist und die andere Paste eine Paste mit metallenen Bestandteilen ist.

9. Verfahren nach einem der vorhergehenden Ansprüche wobei der Folienstapel (18) mit einem weiteren Folienstapel oder einer weiteren Folie laminiert wird.

10. Verfahren nach einem der vorhergehenden Ansprüche wobei Folien (10) für mehrere Stapel (18) beim Stapeln als Bogen verbunden vorliegen und in einem späteren Schritt vereinzelt werden.

11. Verfahren nach einem der vorhergehenden Ansprüche ferner umfassend
- Pressen des Folienstapels (18),
- Entkohlen Folienstapels (18),
- Sintern Folienstapels (18).

12. Mehrschichtträgerkörper (15) aus gestapelten gedruckten Folien (10), die mit verschiedenen Pasten gedruckte Areale (2, 21, 22, 1, 11, 12, 3) aufweisen, **dadurch gekennzeichnet, dass** der Mehrschichtträgerkörper (15) wenigstens eine Kavität (4) aufweist, welche durch ein freies Areal (4), das heißt einer ungedruckten Folienaussparung, gebildet wird und dass der Mehrschichtträgerkörper (15) durch ein Verfahren gemäß einem der vorangehenden Ansprüche hergestellt ist.

## Claims

1. Method for producing a multilayer-carrier body (15), comprising:
- producing films (10) by printing a first area (2, 21, 22, 1, 11, 12, 3) with a first paste and printing a second area (2, 21, 22, 1, 11, 12, 3) with a second paste, wherein the printing is realized in the form of applying the pastes to a carrier, from which the dried pastes are detached as a film (10),
- stacking the films (10),
- laminating,
**characterized in that**, in at least one of the films (10), a free area (4) remains unprinted, or **in that** a third area (3) is printed with a third paste.

2. Method according to claim 1,
wherein the printing is realized by a screen-printing process or an inkjet-printing process.

3. Method according to claim 1 or 2,
wherein, in one of the films (10), the first and second areas (2, 21, 22, 1, 11, 12, 3) at least partially border one another.

4. Method according to any one of the preceding claims, wherein at least one of the films (10) is printed in such a way that at least one of the areas (2, 21, 22, 1, 11, 12, 3) comprises sub-areas (21, 22, 11, 12) which are separate from one another.

5. Method according to any one of the preceding claims, wherein films (10) are printed in such a way
- that a sub-area (21) of the first area surrounds the second area (1) or a sub-area thereof in which, for its part, there is a sub-area (22) of the first area, or
- that the first area (2) or a sub-area thereof surrounds the second area (1) or the sub-area thereof in which, for its part, there is a free area (4) or a third area (3).

6. Method according to any one of the preceding claims, wherein the films (10) are stacked one on top of the other in such a way that the contours of the areas of neighbouring films (10) are differently formed.

7. Method according to any one of the preceding claims, wherein the films (10) are stacked in such a way
- that the first area (2, 21, 22, 1, 11, 12, 3) of one film (10) and the second area (2, 21, 22, 1, 11, 12, 3) of a neighbouring film (10) overlap, or
- that the first area (13) of one film (10) or of multiple films (10) lying one on top of the other at least partially lies between second areas (2) of neighbouring films (10), or
- that the second area (13) of one film (10) or of multiple films (10) lying one on top of the other at least partially lies between first areas (2) of neighbouring films (10).

8. Method according to any one of the preceding claims, wherein one paste of the first and second pastes is a ceramic paste, and the other paste is a paste with metallic constituents.

9. Method according to any one of the preceding claims, wherein the film stack (18) is laminated with a further film stack or a further film.

10. Method according to any one of the preceding claims, wherein, at the time of stacking, films (10) for multiple stacks (18) are combined as a web and are individually separated in a later step.

11. Method according to any one of the preceding claims, further comprising
- pressing the film stack (18),
- decarburizing the film stack (18),
- sintering the film stack (18).

12. Multilayer-carrier body (15) of stacked printed films (10) which have areas (2, 21, 22, 1, 11, 12, 3) printed with different pastes,
**characterized in that**
the multilayer-carrier body (15) has at least one cavity (4) which is formed by a free area (4), that is to say an unprinted film clearance, and **in that** the multilayer-carrier body (15) is produced by a method according to any one of the preceding claims.

## Revendications

1. Procédé de production d'un corps support multicouche (15) comprenant :
- la fabrication de films (10) par impression d'une première zone (2, 21, 22, 1, 11, 12, 3) avec une première pâte et impression d'une deuxième zone (2, 21, 22, 1, 11, 12, 3) avec une deuxième pâte, l'impression étant effectuée sous forme d'application des pâtes sur un support duquel les pâtes séchées sont détachées sous forme de film (10),
- l'empilement des films (10),
- la stratification,
**caractérisé en ce qu'**une zone libre (4) dans au moins un des films (10) reste non imprimée ou **en ce qu'**une troisième zone (3) est imprimée avec une troisième pâte.

2. Procédé selon la revendication 1,
dans lequel l'impression est effectuée par un procédé de sérigraphie ou un procédé d'impression par jet d'encre.

3. Procédé selon la revendication 1 ou 2,
dans lequel les première et deuxième zones (2, 21, 22, 1, 11, 12, 3) sont au moins partiellement adjacentes dans l'un des films (10).

4. Procédé selon l'une quelconque des revendications précédentes,
dans lequel au moins l'un des films (10) est imprimé de telle sorte qu'au moins l'une des zones (2, 21, 22, 1, 11, 12, 3) comprend des zones partielles (21, 22, 11, 12) séparées les unes des autres.

5. Procédé selon l'une quelconque des revendications précédentes,
dans lequel des films (10) sont imprimés de telle sorte
- qu'une zone partielle (21) de la première zone entoure la deuxième zone (1) ou une zone partielle de celle-ci, dans laquelle se trouve à son tour une zone partielle (22) de la première zone, ou
- que la première zone (2) ou une zone partielle de celle-ci entoure la deuxième zone (1) ou sa zone partielle, dans laquelle se trouve à son tour une zone libre (4) ou une troisième zone (3).

6. Procédé selon l'une quelconque des revendications précédentes,
dans lequel les films (10) sont empilés les uns sur les autres de telle sorte que les contours des zones de films adjacents (10) sont formés différemment.

7. Procédé selon l'une quelconque des revendications précédentes,
dans lequel les films (10) sont empilés de telle sorte
- que la première zone (2, 21, 22, 1, 11, 12, 3) d'un film (10) et la deuxième zone (2, 21, 22, 1, 11, 12, 3) d'un film adjacent (10) se chevauchent, ou
- que la première zone (13) d'un film (10) ou de plusieurs films (10) superposés se situe au moins partiellement entre des deuxièmes zones (2) de films (10) voisins, ou
- que la deuxième zone (13) d'un film (10) ou de plusieurs films (10) superposés se situe au moins partiellement entre des premières zones (2) de films (10) voisins.

8. Procédé selon l'une quelconque des revendications précédentes,
dans lequel l'une des première et deuxième pâtes est une pâte céramique et l'autre pâte est une pâte contenant des constituants métalliques.

9. Procédé selon l'une quelconque des revendications précédentes,
dans lequel l'empilement de films (18) est stratifié avec un autre empilement de films ou un autre film.

10. Procédé selon l'une quelconque des revendications précédentes,
dans lequel des films (10) pour plusieurs empilements (18) se présentent sous forme reliée en tant que feuille lors de l'empilement et sont séparés dans une étape ultérieure.

11. Procédé selon l'une quelconque des revendications précédentes,
comprenant en outre
- le pressage de l'empilement de films (18),
- la décarburation de l'empilement de films (18),
- le frittage de l'empilement de films (18).

12. Corps support multicouche (15) de films imprimés empilés (10), qui présente des zones (2, 21, 22, 1, 11, 12, 3) imprimées avec des pâtes différentes, **caractérisé en ce que**
le corps support multicouche (15) présente au moins une cavité (4) qui est formée par une zone libre (4), c'est-à-dire un évidement de film non imprimé, et **en ce que** le corps support multicouche (15) est produit par un procédé selon l'une quelconque des revendications précédentes.
